(19) Europäisches Patentamt
European Patent Office
Office européen des brevets

(11) **EP 2 090 679 A1**

(12) **EUROPÄISCHE PATENTANMELDUNG**

(43) Veröffentlichungstag:
**19.08.2009 Patentblatt 2009/34**

(51) Int Cl.:
**C30B 15/30** *(2006.01)*     **C30B 30/04** *(2006.01)*

(21) Anmeldenummer: **08013892.8**

(22) Anmeldetag: **04.08.2008**

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**
Benannte Erstreckungsstaaten:
**AL BA MK RS**

(30) Priorität: **04.08.2007 DE 102007036944**

(71) Anmelder: **Forschungszentrum Dresden - Rossendorf e.V.**
**01328 Dresden (DE)**

(72) Erfinder:
- **Grants, Ilmars**
  **Lielvarde, LV 5070 (LV)**
- **Gerbeth, Gunter**
  **01328 Dresden (DE)**

(54) **Verfahren zur Reduzierung von Temperaturfluktuationen in Schmelzen**

(57) Die Erfindung betrifft ein Verfahren zur Reduzierung von Temperaturfluktuationen in Halbleiter- oder Metall-Schmelzen. Das Hauptinteresse gilt vor allem Schmelzen in Kristallzüchtungsprozessen wie Gallium-Arsenid (GaAs), Indium-Phosphid (InP) oder Silizium (Si).

Mit der Erfindung werden große Temperaturfluktuationen in der Schmelze unterdrückt, die den Prozess des Kristallwachstums stören bzw. teilsweise unmöglich machen.

Durch den Einsatz dieses Verfahrens können deutlich größere Schmelzvolumina als heute üblich verwendet werden.

Abb. 1

EP 2 090 679 A1

## Beschreibung

Die Erfindung betrifft ein Verfahren zur Reduzierung von Temperaturfluktuationen in Halbleiter- oder Metall-Schmelzen. Das Hauptinteresse gilt vor allem Schmelzen in Kristallzüchtungsprozessen wie Gallium-Arsenid (GaAs), Indium-Phosphid (InP) oder Silizium (Si).

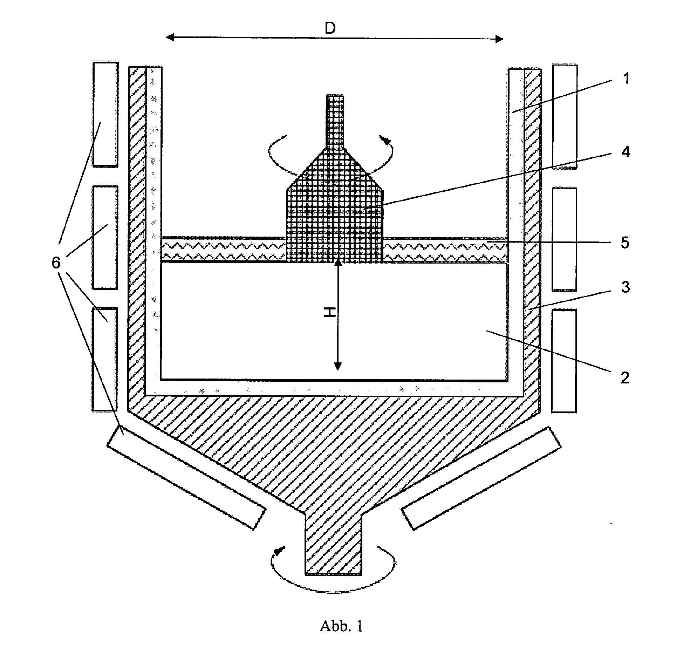

Kristallzüchtungsverfahren aus der Schmelze sind verbreitete Verfahren zur Herstellung von Einkristallen. Bekannt sind z. B. das Czochralski-Verfahren (Cz) zur Herstellung von Silizium-Einkristallen, das Liquid-Encapsulated Czochralski Verfahren (LEC) zur Herstellung von GaAs oder anderen Verbindungshalbleitern, und das Vapour-Controlled Czochralski-Verfahren (VCz). Bei allen diesen Verfahren wird das Ausgangsmaterial in einem Tiegel **1** aufgeschmolzen, wobei die Beheizung des Tiegels durch Heizer **6** erfolgt, die unter oder an den Seiten des Tiegels angeordnet sind, siehe Abb. 1. Der Tiegel kann sich in einem Tiegelhalter **3** befinden. Die Züchtung des jeweiligen Einkristalls **4** erfolgt dann durch Aufsetzen eines Impfkristalls auf die Schmelze **2** auf der Achse der axialsymmetrischen Anordnung und langsames Herausziehen des Kristalls aus der Schmelze. Dabei können Tiegel und Kristall unabhängig voneinander um die Mittelachse rotieren. Beim LEC-Verfahren wird die freie Oberfläche der Schmelze noch durch eine Boroxidschicht **5** bedeckt, um das Verdampfen flüchtiger Komponenten zu verhindern. Der Tiegel ist zylindersymmetrisch. Er hat meist eine unten abgerundete Form, wie in Abb. 1 skizziert, kann aber auch ein Zylinder sein. Die Schmelze **2** im Tiegel **1** ist durch den Tiegelinnendurchmesser $D = 2\,R$ und die Schmelzhöhe $H = 2\,h$ charakterisiert, wobei $R$ der Tiegelinnenradius und $h$ die halbe Schmelzhöhe ist (siehe Abb. 1). In der Schmelze bestehen Temperaturgradienten, da die Phasengrenze festflüssig am wachsenden Kristall gleich der Schmelztemperatur des jeweiligen Materials ist, die Schmelze im übrigen aber durch die externen Heizer **6** im flüssigen Zustand gehalten wird. Die über die Heizer zugeführte Wärme wird entweder über den Kristall oder die Oberfläche der Schmelze abgeführt.

Bedingt durch die Temperaturgradienten in der Schmelze, aber auch die Rotation von Tiegel oder Kristall, existieren in der Schmelze relativ komplexe Strömungen. Die Heizungen am Tiegel bewirken eine Auftriebsströmung in der Schmelze, die durch die dimensionslose Grashof-Zahl

$$Gr = \frac{\alpha\, g\, \Delta T\, h^4}{\nu^2}$$

charakterisiert ist, wobei $\alpha$ den Volumenausdehnungskoeffizienten der Schmelze, $g$ die Erdbeschleunigung, $\Delta T$ eine typische Temperaturdifferenz über der Schmelze und $\nu$ die kinematische Viskosität der Schmelze bezeichnen. Die Auftriebsströmung wird durch Strömungen überlagert, die von der mechanischen Rotation des Kristalls oder des Tiegels hervorgerufen sind. Zusätzlich ist die freie Schmelzoberfläche bzw. die freie Oberfläche der Boroxidabdeckung zwischen Kristall und Tiegelwand noch Quelle einer oberflächenspannungsgetriebenen Marangoni-Strömung. Im Wechselspiel dieser strömungsantreibenden Wirkungen stellt sich in der Schmelze im Allgemeinen ein komplexes, zeitlich variierendes Strömungsregime ein. Für Tiegeldurchmesser $D \geq 20$ cm ist die Strömung stets turbulent mit entsprechenden Fluktuationen der Strömungsgeschwindigkeit und der lokalen Temperaturen. Es ist bekannt, dass die Temperaturfluktuationen mit wachsender Grashof-Zahl Gr stetig zunehmen (Chandrasekhar: Hydrodynamic and Hydromagnetic Stability. Clarendon, 1961).

Die Temperaturfluktuationen in der Schmelze stellen ein wesentliches Problem für die Kristallzüchtung dar. Sie führen zu Schwankungen der Wachstumsgeschwindigkeit, die am fertigen Kristall Wachstumsstreifen (so genannte striations) hervorrufen oder zur so genannten Zwillingsbildung im Kristall führen. Werden die Temperaturfluktuationen zu groß, wird durch den ständigen Wechsel von Kristallisation und Rückschmelzen an der Phasengrenze die Herstellung eines Einkristalls praktisch völlig unmöglich. Die Kontrolle und Reduzierung der Temperaturfluktuationen in der Schmelze ist deshalb von zentralem Interesse für die Weiterentwicklung von Kristallzüchtungsverfahren. Die starke Abhängigkeit der Grashof-Zahl *Gr* von der Schmelzhöhe *h* und das stetige Wachsen der Temperaturfluktuationen mit Gr haben in der Praxis zur Folge, dass meist nur relativ geringe Schmelzhöhen möglich sind, d.h. die Tiegel bei den LEC-, Cz- oder VCz-Verfahren nur mit Schmelzhöhen befüllt werden können, die kleiner als der Tiegeldurchmesser sind. Das jedoch begrenzt von vornherein Durchmesser und Länge des gezogenen Kristalls. Zur Qualitäts- und Produktivitätssteigerung bei Kristallzüchtungsverfahren wäre es wünschenswert, den Züchtungsprozess mit größeren Schmelzeinwaagen und Schmelzhöhen zu beginnen, ohne dass die unvermeidlichen Temperaturfluktuationen einen zu großen Wert annehmen.

Zur Reduzierung der Temperaturfluktuationen im Cz-Züchtungsprozess wurde von Whiffin und Brice: J. Crystal Growth. Vol. 10, 91-96, 1971 der Einsatz von Strömungsgittern in der Schmelze vorgeschlagen. In der Schrift DE 10 2005 043 623 A1 wird zur Kontrolle der Temperaturfluktuationen die Oberflächentemperatur im Tiegelinnenraum erfasst, um beim Auftreten von größeren Temperaturfluktuationen durch Änderung der Kristallrotation darauf zu reagieren. Die Beeinflussung der Temperaturfluktuationen allein durch die Kristallrotation ist jedoch begrenzt und für größere Kristalldurchmesser bei weitem nicht ausreichend. Temperaturfluktuationen können durch die Rotation des Tiegels unterbunden werden (Chandrasekhar: Hydrodynamic and Hydromagnetic Stability. Clarendon, 1961). Allerdings erfordern große Werte der Grashof-Zahl *Gr* auch hohe Tiegelrotationsraten, die für praktisch interessierende Tiegelgrößen nicht mehr praktikabel sind.

Halbleiter- und Metallschmelzen sind gute elektrische Leiter, deren Strömung deshalb durch Magnetfelder stark beeinflusst werden kann. Insbesondere statische Magnetfelder sind dafür bekannt, dass sie im Allgemeinen eine bremsende Wirkung auf Schmelzströmungen haben, die mit einer Verringerung der Strömungs- und damit auch der Temperaturfluktuationen verbunden ist. Für Kristallzüchtungsverfahren wurden verschiedene Formen statischer Magnetfelder vorgeschlagen (D.T.J. Hurle (Editor): Handbook of Crystal Growth. Elesevier, 1994; US 4904336; DD 270728A1), die axiale, transversale oder axial-radiale (so genannte cusp) Magnetfeld-Geometrien umfassen. Die Verwendung von statischen Magnetfeldern hat aber auch Nachteile, z. B. die Erhöhung des radialen Temperaturgradienten infolge der Unterdrückung der Schmelzströmung. Statische Magnetfelder sind in der Lage, die Temperaturfluktuationen zu reduzieren, allerdings wächst für praktisch interessierende Tiegelgrößen und deren typische Grashof-Zahlen Gr der Aufwand für die erforderlichen Magnetfelder enorm.

Alternierende Magnetfelder erzeugen unmittelbar eine Kraftwirkung auf jedes Fluidvolumen der Schmelze. Auf diese Weise ist eine aktive, strömungsantreibende Wirkung möglich. Der Einsatz von rotierenden Magnetfeldern in Kristallzüchtungsverfahren ist von Gelfgat: J. Crystal Growth. Vol. 198-199, 165, 1999 beschrieben worden, wobei in dieser Arbeit das rotierende Magnetfeld nur für die Zwecke der Homogenisierung mehrkomponentiger Schmelzen und zur Beeinflussung der Form der Phasengrenzfläche betrachtet wird. Ein rotierendes Magnetfeld erzeugt primär eine azimuthale Strömung der Schmelze und erhöht damit die Axialsymmetrie des gesamten Züchtungsprozesses. Die Relativbewegung der Schmelze zum Tiegel bewirkt eine radial-meridionale Strömung, die im Allgemeinen etwa 5 bis 10fach schwächer ist als die primär azimuthale Rotation. Der Einsatz von rotierenden Magnetfeldern in der Kristallzüchtung wurde bisher vor allem zur Beeinflussung der Form der Phasengrenze und zur Beeinflussung des Dotierstoff- bzw. Sauerstofftransports untersucht.

Die strömungsantreibende Wirkung eines alternierenden Magnetfeldes kann aber auch zu einer Anfachung von Fluktuationen in der Schmelze führen. Folglich wurde auch die Kombination von statischen und alternierenden Magnetfeldern untersucht, um möglichst optimale Magnetfeldwirkungen für verschiedene Kristallzüchtungsverfahren zu ermitteln. Die Schriften DE 19 529 481 A1 und DE 19 704 075 C2 beschreiben solche Kombinationen, wobei das statische Magnetfeld jeweils die Funktion hat, die u.a. vom alternierenden Magnetfeld getriebenen Strömungen und damit verbundenen Fluktuationen zu reduzieren. Es ist offensichtlich, dass solch kombinierte Magnetsysteme einen erhöhten Aufwand an externen Magnetfeldern und zugehörigen Stromversorgungen darstellen. Die Ziele der in den Schriften DE 195 29 481 A1 und DE 19 704 075 C2 offenbarten Lösungen lagen stets in der Form der Phasengrenze und einer homogeneren Verteilung der Dotierstoff- bzw. Sauerstoffverteilungen. Von einer möglichen Vergrößerung der anfänglichen Schmelzhöhe im Tiegel ist in beiden Schriften nicht die Rede.

Die Aufgabe der vorliegenden Erfindung besteht darin, die in beheizten Halbleiter-oder Metallschmelzen auftretenden Temperaturfluktuationen signifikant zu reduzieren bzw. zu unterdrücken, weil diese Temperaturfluktuationen den Prozess des Kristallwachstums stören und/oder teilweise unmöglich machen und um auf diese Weise in Kristallzüchtungsverfahren deutlich größere, anfängliche Schmelzhöhen im Tiegel zu ermöglichen, also größere Schmelzvolumina verarbeiten zu können.

Erfindungsgemäß wird die Aufgabe mit den in den Patentansprüchen dargelegten Merkmalen gelöst. Die Erfindung basiert zum Einen darauf, dass ein rotierendes Magnetfeld ab einer bestimmten Stärke seiner strömungsantreibenden Wirkung die in einem axialsymmetrischen Tiegel vorhandene, durch andere strömungsantreibende Kräfte (Auftrieb, Marangoni, Rotation von Tiegel oder Kristall) bedingte, turbulente Strömung mit im Allgemeinen großen niedrig-frequenten Fluktuationen in eine andersartige turbulente Strömung mit deutlich reduzierten, kleinskaligen und höherfrequenten Fluktuationen ändert und zum Anderen in der Festlegung der Parameter für das rotierende Magnetfeld. Dieser Übergang der Strömungsform hat in beheizten Schmelzen eine signifikante Reduzierung der Temperaturfluktuationen zur Folge.

Die Wirkung des rotierenden Magnetfeldes wird durch die dimensionslose Taylor-Zahl

$$Ta = \frac{\sigma\,\omega\,B^2\,h^4}{2\,\rho\,\nu^2}$$

beschrieben, wobei σ die elektrische Leitfähigkeit der Schmelze, ρ die Dichte der Schmelze, ω die Frequenz des rotierenden Magnetfeldes und *B* die Amplitude des rotierenden Magnetfeldes bezeichnen. Die durch das rotierende Magnetfeld angetriebene azimuthale Strömung im Tiegel wächst stetig mit wachsendem *Ta*. Die Wirkung des rotierenden Magnetfeldes wird noch durch einen zweiten dimensionslosen Parameter beschrieben, den Abschirmparameter

$$S = \sigma\,\mu\,\omega\,R^2$$

der für wachsendes *S* die zunehmende Abschirmung des rotierenden Magnetfeldes durch die leitfähige Schmelze beschreibt, wobei μ die magnetische Permeabilität der Schmelze bezeichnet.

Der für die Reduzierung der Temperaturfluktuationen entscheidende Strömungsübergang von einer großskaligen, turbulenten Auftriebsströmung mit großen, niedrigfrequenten Fluktuationen zu einer turbulenten Strömung mit deutlich kleineren Fluktuationen setzt in robuster Weise ein, falls die Taylor-Zahl $Ta$ des rotierenden Magnetfeldes einen Schwellwert $Ta_c$ übersteigt. Mit deutlich kleineren Fluktuationen ist gemeint, dass die Temperaturfluktuationen in der Schmelze im Bereich der Tiegelwand mindestens um den Faktor 3, im Innern der Schmelze mindestens um den Faktor 5 im Vergleich zur Strömung ohne rotierendes Magnetfeld verringert werden. Dieser Strömungsübergang setzt in dieser robusten und deutlich ausgeprägten Weise nur ein, falls der Abschirmparameter den Wert von $S = 30$ nicht übersteigt. Der Schwellwert $Ta_c$ der Taylor-Zahl für diesen Strömungsübergang beträgt mindestens

$$Ta_c = 5 \cdot Gr^{0.75}$$

für Auftriebsströmungen mit Grashof-Zahlen von $Gr > 10^6$. Oberhalb dieses Schwellwertes wird die Strömung in der Schmelze durch das rotierende Magnetfeld klar dominiert. Dieser durch das rotierende Magnetfeld bewirkte Strömungsübergang hin zu einer Strömung mit deutlich geringeren Temperaturfluktuationen setzt auch ein, falls die Basisströmung nicht nur durch Auftrieb, sondern auch durch mechanische Rotationen von Tiegel oder Kristall oder durch Marangoni-Strömungen bedingt ist.

Wesentlich ist der Unterschied der Wirkung des rotierenden Magnetfeldes im Vergleich zu einer einfachen mechanischen Rotation des Tiegels. Mittels Rotation des Tiegels besteht grundsätzlich auch die Möglichkeit, die Temperaturfluktuationen in der Schmelze zu reduzieren. Allerdings wären im Vergleich zu der hier beschriebenen Wirkung des rotierenden Magnetfeldes dafür hohe Drehraten erforderlich, die für Kristallzüchtungsverfahren unrealistisch sind. Der physikalische Grund für den Unterschied zwischen mechanischer Rotation und der Wirkung des rotierenden Magnetfeldes liegt darin, dass das rotierenden Magnetfeld eine Kraftwirkung auf jedes Fluidvolumen im Innern der Schmelze ausübt, während im Falle der mechanischen Rotation die primäre Wirkung auf die Schmelze nur an der Wand des Tiegels entsteht.

Die Erfindung wird nachfolgend am Ausführungsbeispiel 1 erläutert. In einem zylindrischen Behälter der Maße $R = h = 70$ mm befindet sich die metallische Schmelze flüssiges Gallium. Mittels Thermostaten werden Boden und Deckel des Behälters auf konstanten, aber unterschiedlichen Temperaturen gehalten. Die Bodentemperatur $T_B$ ist höher als die des Deckels $T_D$ und

die Temperaturdifferenz $\Delta T = T_B - T_D$ nimmt Werte bis zu $50$ K an. In Abhängigkeit von dieser Temperaturdifferenz kann die Grashof-Zahl in dieser Anordnung Werte bis zu $Gr = 10^8$ annehmen. Für Grashof-Zahlen $Gr > 10^6$ ist die Strömung in der Gallium-Schmelze turbulent. Die turbulenten Temperaturfluktuationen in der Schmelze haben Amplituden, die für $Gr > 5.10^7$ mindestens $\pm 4$ K betragen. Wird die Gallium-Schmelze einem rotierenden Magnetfeld ausgesetzt, so tritt der genannte Strömungsübergang von einer großskaligen Auftriebsströmung mit großen Fluktuationen zu einer kleinskaligen Strömung mit deutlich geringeren Fluktuationen oberhalb des Schwellwertes

$$Ta_c = 5 \cdot Gr^{0.75}$$

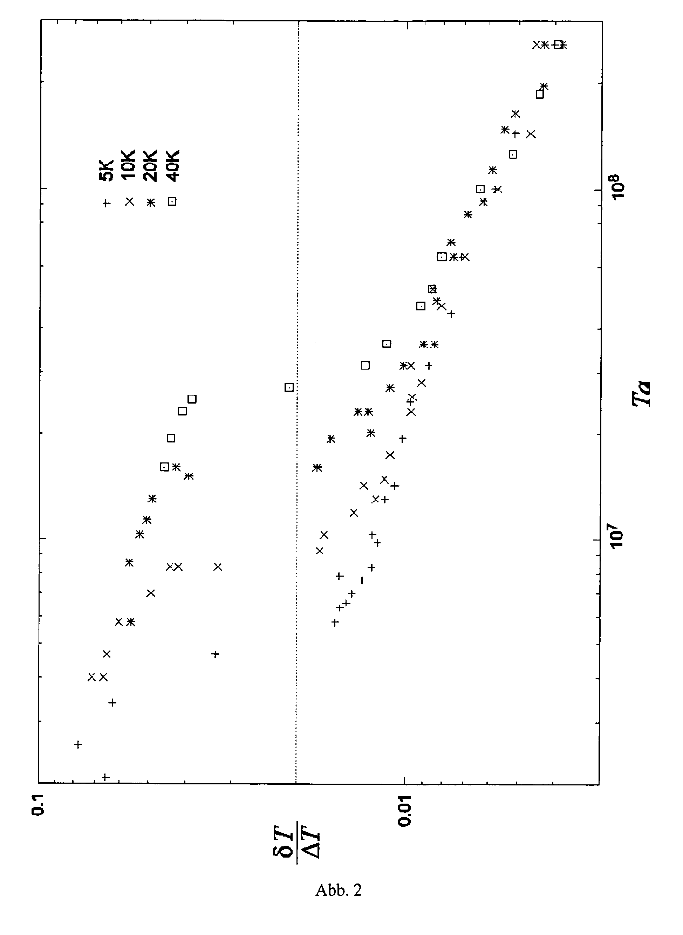

auf, wie die in Abb. 2 dargestellten Messungen der Temperaturfluktuationen zeigen. Dieser Strömungsübergang wird nur für Werte des Abschirmparameters von $S < 30$ gefunden. Abb. 2 zeigt auch, dass die Temperaturfluktuationen nach dem Strömungsübergang bei $Ta_c$ mit wachsendem Ta weiter stetig reduziert werden. Im Innern der Gallium-Schmelze werden noch deutlich stärkere Reduzierungen der Temperaturfluktuationen gemessen, die bis zu Faktor 50 erreichen im Vergleich zur Strömung ohne das rotierende Magnetfeld.

Ausführungsbeispiel 2 betrachtet einen 12"-Tiegel ($D \approx 30.5$ cm), wie er typischerweise in Cz-Kristallzüchtungen auftritt, der mit einer GaAs-Schmelze der Höhe $H = 30$ cm gefüllt ist. Eine im Kristallzüchtungsprozess charakteristische Temperaturdifferenz von $\Delta T = 20$ K entspricht einer Grashof-Zahl von $Gr \approx 6 \cdot 10^8$. Eine solche Füllhöhe ist nach dem Stand der Technik nicht möglich für die GaAs-Kristallzüchtung, da für diesen Bereich der Grashof-Zahl die Auftriebsströmung hochturbulent ist mit großen Temperaturfluktuationen. Eine signifikante Reduzierung der Temperaturfluktuationen durch mechanische Rotation des Tiegels würde Rotationsraten des Tiegels von etwa $65$ rpm erfordern, was nicht praktikabel ist. Die Reduzierung der Temperaturfluktuationen mittels eines rotierenden Magnetfeldes erfordert entsprechend der Abhängigkeit des Schwellwertes $Ta_c$ von $Gr$ eine Taylor-Zahl von ca. $Ta = 1.5.10^8$, was für GaAs und die genannten Dimensionen der Schmelze ein rotierendes Magnetfeld der Amplitude $B = 1$ mT bei einer Feldfrequenz von 50 Hz (entspricht einem Abschirmparameter von ca. $S = 8$) bedeuten würde. Die azimuthale Rotation der Schmelze würde dafür lediglich etwa 6 rpm betragen, was im Bereich der heute praktizierten mechanischen Rotation des Schmelzetiegels liegt. Die Strömungsbeeinflussung durch ein rotierendes Magnetfeld geringer Amplitude würde somit eine deutlich höhere anfängliche Füllhöhe im Tiegel erlauben.

**Bezugszeichenliste**

1 Tiegel
2 Schmelze
3 Tiegelhalter
4 Kristall
5 Abdeckung der Schmelzoberfläche
6 Heizer

Abb. 1: Skizze der Anordnung von Tiegel und Schmelze (D=2R, H=2h)

Abb. 2: Temperaturfluktuation in der Gallium-Schmelze an der Tiegelwand gemessen (Standardabweichung δT im Verhältnis zur angelegten Temperaturdifferenz ΔT als Funktion der Taylor-Zahl des rotierenden Magnetfeldes)

**Patentansprüche**

1. Verfahren zum kontaktlosen Rühren von Halbleiter- und Metallschmelzen in beheizten Behältern, **dadurch gekennzeichnet, dass** die in der Schmelze vorhandenen turbulenten Temperaturschwankungen durch die strömungsantreibende Wirkung eines rotierenden Magnetfeldes signifikant, das heißt wenigstens um den Faktor 3 im Vergleich zum Fall ohne Magnetfeld reduziert werden.

2. Verfahren nach Anspruch 1, **dadurch gekennzeichnet, dass** im Falle einer auftriebsbedingten Grundströmung im Tiegel die Taylor-Zahl

$$Ta = \frac{\sigma \omega B^2 h^4}{2 \rho \nu^2}$$

des rotierenden Magnetfeldes größer als der Schwellwert $Ta_c = 5.Gr^{0.75}$ gewählt wird, wobei

$$Gr = \frac{\alpha g \Delta T h^4}{\nu^2}$$

eine die Auftriebsströmung charakterisierende, dimensionslose Kennzahl ist, die mit $\alpha$, $\rho$, $\nu$, $\sigma$ als Volumenausdehnungskoeffizient, Dichte, kinematische Viskosität und elektrische Leitfähigkeit der Schmelze, $g$ als Erdbeschleunigung, $\Delta T$ als typische Temperaturdifferenz über der Schmelze, $h$ als halbe Höhe der Schmelze, sowie $\omega$ und $B$ als Frequenz und Amplitude des rotierenden Magnetfeldes ermittelt werden.

3. Verfahren nach Anspruch 1, **dadurch gekennzeichnet, dass** die Frequenz des rotierenden Magnetfeldes so gewählt wird, dass der dimensionslose Abschirmparameter $S = \mu \sigma \omega R^2$ den Wert $S = 30$ nicht übersteigt, wobei $\mu$ die magnetische Permeabilität der Schmelze bezeichnet.

4. Verfahren nach Anspruch 1, **dadurch gekennzeichnet, dass** für eine effiziente Wirkung des rotierenden Magnetfeldes dessen Frequenz so gewählt wird, dass der dimensionslose Abschirmparameter S im Bereich $5 < S < 10$ liegt.

5. Verfahren nach Anspruch 2, **dadurch gekennzeichnet, dass** die Temperaturfluktuationen in der Schmelze stetig weiter reduziert werden können durch Erhöhung der Taylor-Zahl des rotierenden Magnetfeldes über den Schwellwert $Ta_c$ hinaus.

6. Verfahren nach Anspruch 1, **dadurch gekennzeichnet, dass** die Reduzierung der Temperaturfluktuationen durch den Einsatz des rotierenden Magnetfeldes zu einer größeren Einwaage bzw. größeren Füllhöhe der anfänglichen Schmelze in Kristallzüchtungsverfahren eingesetzt wird.

7. Verfahren nach Anspruch 2 und 6, **dadurch gekennzeichnet, dass** die Amplitude des rotierenden Magnetfeldes im Verlauf des Kristallzüchtungsprozesses der sich kontinuierlich verringernden Schmelzhöhe angepasst wird.

Abb. 1

Abb. 2

Europäisches Patentamt
European Patent Office
Office européen des brevets

## EUROPÄISCHER RECHERCHENBERICHT

Nummer der Anmeldung

EP 08 01 3892

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | FISCHER B ET AL: "The use of time-dependent magnetic fields for control of convective flows in melt growth configurations" JOURNAL OF CRYSTAL GROWTH, ELSEVIER, AMSTERDAM, NL, Bd. 198-199, 1. März 1999 (1999-03-01), Seiten 170-175, XP004170848 ISSN: 0022-0248 * das ganze Dokument * ----- | 1-7 | INV. C30B15/30 C30B30/04 |
| X | DOLD P: "Czochralski growth of doped germanium with an applied rotating magnetic field" CRYSTAL RESEARCH AND TECHNOLOGY WILEY-VCH VERLAG BERLIN GMBH GERMANY, Bd. 38, Nr. 7-8, 2003, Seiten 659-668, XP002535707 ISSN: 0232-1300 * das ganze Dokument * ----- | 1-7 | |
| X | DOLD P ET AL: "MODIFICATION OF FLUID FLOW AND HEAT TRANSPORT IN VERTICAL BRIDGMAN CONFIGURATIONS BY ROTATING MAGNETIC FIELDS" 1. Januar 1997 (1997-01-01), CRYSTAL RESEARCH AND TECHNOLOGY, WILEY - V C H VERLAG GMBH & CO. KGAA, WEINHEIM, DE, PAGE(S) 51 - 60 , XP000989948 ISSN: 0232-1300 * das ganze Dokument * ----- | 1-7 | RECHERCHIERTE SACHGEBIETE (IPC) C30B |

Der vorliegende Recherchenbericht wurde für alle Patentansprüche erstellt

| Recherchenort | Abschlußdatum der Recherche | Prüfer |
|---|---|---|
| München | 7. Juli 2009 | Brisson, Olivier |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
.................................................................
& : Mitglied der gleichen Patentfamilie, übereinstimmendes Dokument

EPO FORM 1503 03.82 (P04C03)

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102005043623 A1
- US 4904336 A
- DD 270728 A1
- DE 19529481 A1
- DE 19704075 C2

**In der Beschreibung aufgeführte Nicht-Patentliteratur**

- **CHANDRASEKHAR.** Hydrodynamic and Hydromagnetic Stability. *Clarendon,* 1961
- **WHIFFIN ; BRICE.** *J. Crystal Growth,* 1971, vol. 10, 91-96
- Handbook of Crystal Growth. Elesevier, 1994
- **GELFGAT.** *J. Crystal Growth,* 1999, vol. 198-199, 165